# EUROPÄISCHE PATENTSCHRIFT

(11) **EP 1 875 468 B1**
(45) Veröffentlichungstag und Bekanntmachung des Hinweises auf die Patenterteilung: **01.07.2009**
(21) Anmeldenummer: 06724436.8
(22) Anmeldetag: 20.04.2006
(51) Int. Cl.: G11B 7/26, C23C 14/50, G11B 7/24

(54) **VORRICHTUNG UND VERFAHREN ZUM BESCHICHTEN VON SCHEIBENFÖRMIGEN SUBSTRATEN FÜR OPTISCHE DATENTRÄGER**
PROCESS AND DEVICE FOR COATING DISK-SHAPED SUBSTRATES FOR OPTICAL DATA CARRIERS
DISPOSITIF ET PROCEDE POUR APPLIQUER UN REVETEMENT SUR DES SUBSTRATS DISCOIDES POUR SUPPORTS DE DONNEES OPTIQUES

(30) Priorität: 26.04.2005 DE 102005019383
(43) Veröffentlichungstag der Anmeldung: 09.01.2008
(73) Patentinhaber: Steag HamaTech AG, 75447 Sternenfels (DE)
(72) Erfinder: WEINDEL, Christian, 75433 Maulbronn (DE); LUKHAUB, Waldemar, 71665 Vaihingen (DE)
(74) Vertreter: Wagner & Geyer
(86) Internationale Anmeldenummer: PCT/EP2006/003592
(87) Internationale Veröffentlichungsnummer: WO 2006/114227

(56) Entgegenhaltungen:
- EP-A- 0 449 227
- EP-A- 1 029 942
- EP-A- 1 422 705
- EP-A- 1 575 041
- US-A- 4 969 790
- US-A1- 2001 010 204

## Beschreibung

Die vorliegend Erfindung bezieht sich auf eine Vorrichtung und ein Verfahren zum Beschichten von scheibenförmigen Substraten für optische Datenträger.

Bei der Herstellung optischer Datenträger, wie beispielsweise CDs, DVDs, Blu-ray und ihren jeweiligen Unterformaten ist es notwendig, reflektierende Schichten auf einem Trägersubstrat aufzubringen. Je nach dem zu bildenden optischen Datenträger, kann es notwendig sein eine Schicht auf einem einzelnen Trägersubstrat aufzubringen (Single-Layer-Format) oder zwei Schichten aus meist unterschiedlichen Materialien bzw. Materialzusammensetzungen auf zwei unterschiedlichen Trägersubstraten aufzubringen (Dual-Layer-Format). Für die Zukunft ist es auch denkbar, zwei oder mehr Schichten aus gegebenenfalls unterschiedlichen Materialien auf Trägersubstraten aufzubringen.

Die Beschichtung erfolgt in der Regel über Sputtervorrichtungen, in denen ein Target aus dem Beschichtungsmaterial zerstäubt wird, um die Trägersubstrate zu beschichten. Dabei erfolgt die Beschichtung jeweils in einem Vakuum.

Die US 4 969 790 A beschreibt ist eine Vorrichtung zum Beschichten von Substraten in einer Vakuumkammer gemäß dem Oberbegriff des Anspruchs 1.

Für die Herstellung von Single-Layer-Formaten und Dual-Layer-Formaten wurden jeweils unterschiedliche Sputtervorrichtungen eingesetzt, wobei für die Herstellung von Dual-Layer-Formaten zwei getrennte Beschichtungsvorrichtungen mit getrennten Schleusen-, Transport- und Sputterkammern eingesetzt wurden. Dabei ergibt sich der Nachteil, dass eine relativ hohe Anzahl von Sputtervorrichtungen, insbesondere für Dual-Layer-Formate notwendig ist, die jeweils eigene Schleusen- und Transportkammern mit entsprechenden Transporteinheiten benötigen.

Ausgehend von den bekannten Beschichtungsvorrichtungen liegt der vorliegenden Erfindung daher die Aufgabe zugrunde, eine Vorrichtung und ein Verfahren zum Beschichten von scheibenförmigen Substraten für optische Datenträger vorzusehen, das auf einfache und kostengünstige Weise eine Beschichtung von Substraten, insbesondere eine parallele Beschichtung von getrennten Substraten für Dual-Layer-Formate ermöglicht.

Erfindungsgemäß wird die Aufgabe durch eine Vorrichtung nach Anspruch 1 und ein Verfahren nach Anspruch 9 gelöst. Weitere Ausgestaltungen der Erfindung ergeben sich aus den Unteransprüchen.

Insbesondere weist die Vorrichtung ein Gehäuse zur Bildung einer Vakuumkammer auf, wobei das Gehäuse wenigstens zwei Beschichtungsöffnungen und wenigstens eine Ein-/Ausgabeöffnung aufweist, wobei wenigstens zwei Substrate gleichzeitig über die Ein-/Ausgabeöffnung(en) in die Vakuumkammer hinein bzw. aus dieser heraus geladen werden können. Ferner sind wenigstens zwei Zerstäubungskathodenanordnungen vorgesehen, wobei jede Zerstäubungskathodenanordnung eine der Beschichtungsöffnungen in des Gehäuses von außen vakuumdicht verschließt, und die Zerstäubungskathodenanordnungen jeweils ein zu zerstäubendes Target besitzen, eine innerhalb der Vakuumkammer angeordnete Transporteinrichtung zum gleichzeitigen Transport von wenigstens vier Substraten zwischen der wenigstens einen Ein-/Ausgabeöffnung und den Beschichtungsöffnungen, sowie eine Steuereinheit zum Steuern der Transporteinrichtung in Abhängigkeit von einem erwünschten Beschichtungsergebnis derart, dass die Substrate von wenigstens einer Ein-/Ausgabeöffnung sequentiell zu einer ersten Beschichtungsöffnung, einer zweiten Beschichtungsöffnung und anschließend zu wenigstens einer Ein-/Ausgabeöffnung transportiert werden (serielle Steuerung) oder derart, dass die Substrate von wenigstens einer Ein-/Ausgabeöffnung zu einer Beschichtungsöffnung und anschließend direkt zu wenigstens einer Ein-/Ausgabeöffnung transportiert werden (parallele Steuerung). Die obige Vorrichtung ermöglicht bei geringem apparativem Aufwand einerseits die Herstellung von Single- und Dual-Layer-Formaten bei einer parallelen Steuerung der Transportvorrichtung, sowie die Beschichtung von Substraten mit zwei oder mehr Schichten während einer seriellen Steuerung der Transportvorrichtung. Somit lässt sich dieselbe Vorrichtung für unterschiedliche Formate einsetzen, und für die Dual-Layer-Formate kann eine einzelne Anlage vorgesehen werden. Darüber hinaus ist es insbesondere bei der Beschichtung eines Substrats mit mehreren Schichten nicht notwendig, die Substrate zwischen den unterschiedlichen Beschichtungsvorgängen in unterschiedliche Beschichtungsvorrichtungen mit eigenen Schleusenkammern, Transportvorrichtungen etc. ein- und wieder auszuschleusen. Dies reduziert wesentlich den apparativen sowie den steuerungstechnischen Aufwand. Die obige Vorrichtung ist insbesondere für die Beschichtung mehrerer Substrate für Single- oder Dual-Layer-Formaten vorgesehen, wobei innerhalb einer einzelnen Vorrichtung mit einer einzelnen Transporteinrichtung und einer einzelnen Vakuumkammer wenigstens zwei Substrate gleichzeitig beschichtet werden können.

Vorzugsweise sind die Ein-/Ausgabeöffnung(en) und die Beschichtungsöffnungen in einer gemeinsamen Wand des Gehäuses ausgebildet, was die Be- und Entladung von Substraten vereinfacht und auch einen einfachen Aufbau der Transportvorrichtung ermöglicht.

Gemäß einer bevorzugten Ausführungsform der Erfindung weisen wenigstens zwei Zerstäubungskathodenanordnungen Targets mit unterschiedlichen Materialien auf, was insbesondere für die Herstellung von Dual-Layer-Formaten meist notwendig ist. Jedoch können auch Single-Layer-Formate mit unterschiedlichen Schichten, sofern dies erforderlich ist, hergestellt werden.

Gemäß einem besonders bevorzugten Ausführungsbeispiel der Erfindung trägt die Transporteinrichtung die Substrate im Wesentlichen in einer horizontalen Ausrichtung, was eine gute Anbindung an bestehende Herstellungssysteme ermöglicht, in denen die Substrate in der Regel in einer horizontalen Ausrichtung getragen werden. Eine Lageänderung der Substrate ist daher nicht notwendig, was den Aufbau und die Steuerung entsprechender Handhabungsvorrichtungen erleichtert. Vorzugsweise ist die Wand des Gehäuses eine obere Wand des Gehäuses, was das Be- und Entladen der Substrate erleichtert und insbesondere den Zugriff auf die Zerstäubungskathodenanordnungen, beispielsweise zum Targetaustausch oder zur Wartung, erleichtert.

Vorzugsweise weist die Transporteinrichtung eine drehbare Transporteinheit mit wenigstens vier Aufnahmen und wenigstens eine separate Hubeinheit auf. Durch die Trennung der drehbaren Transporteinheit von der Hubeinheit, lassen sich die jeweiligen Einheiten einfach aufbauen und steuern. Die Hubeinheiten sind dabei notwendig, um die Substrate bzw. Substratteller zu den Ein-/Ausgabeöffnungen und/oder den Beschichtungsöffnungen hin und von diesen weg zu bewegen.

Vorzugsweise sind wenigstens zwei separate Hubeinheiten vorgesehen, um beispielsweise für die Ein-/Ausgabeöffnungen und die Beschichtungsöffnungen unterschiedliche Hubeinheiten vorzusehen. Dabei sind vorzugsweise Hubelemente der Hubeinheiten mit den jeweiligen Öffnungen in der einen Wand ausgerichtet.

Bei einem Verfahren zum Beschichten von scheibenförmigen Substraten für optische Datenträger unter Verwendung einer zuvor beschriebenen Vorrichtung werden wenigstens zwei Substrate gleichzeitig über die wenigstens eine Ein-/Ausgabeöffnung in die Vakuumkammer geladen, gleichzeitig durch die Transporteinrichtung zu einer jeweiligen Beschichtungsöffnung transportiert, und an der jeweiligen Beschichtungsöffnung gleichzeitig beschichtet. Hierdurch lassen sich innerhalb derselben Vorrichtung zwei Substrate gleichzeitig beschichten, was einen hohen Durchsatz bei reduziertem apparativem Aufwand ermöglicht.

Bei einem alternativen Verfahren zum Beschichten von scheibenförmigen Substraten für optische Datenträger unter Verwendung einer zuvor beschriebenen Vorrichtung wird ein Substrat über die wenigstens eine Ein-/Ausgabeöffnung in die Vakuumkammer geladen, durch die Transporteinrichtung zu einer ersten Beschichtungsöffnung transportiert, an der ersten Beschichtungsöffnung beschichtet, und anschließend durch die Transporteinrichtung zu einer zweiten Beschichtungsöffnung transportiert und an dieser mit einer zweiten Schicht beschichtet, wobei die erste und zweite Schicht aus unterschiedlichen Materialien bestehen. Bei diesem Verfahren lassen sich Substrate innerhalb einer einzelnen Vorrichtung auf einfache und kostengünstige Weise mit unterschiedlichen Schichtmaterialien beschichten. Dabei werden an der ersten und zweiten Beschichtungsöffnung gleichzeitig unterschiedliche Substrate beschichtet, so dass während das eine Substrat an der zweiten Beschichtungsöffnung mit der zweiten Schicht beschichtet wird, ein weiteres Substrat an der ersten Beschichtungsöffnung mit der ersten Schicht beschichtet werden kann. Hierdurch ergibt sich ein hoher Durchsatz für die Anlage.

Bei einer besonders bevorzugten Ausführungsform der Erfindung werden die Substrate während der Beschichtung stationär gehalten, was für eine homogene Beschichtung der Substratscheiben vorteilhaft ist.

Die Erfindung wird nachfolgend anhand eines bevorzugten Ausführungsbeispiels unter Bezugnahme auf die Zeichnungen näher erläutert; in den Zeichnungen zeigen:

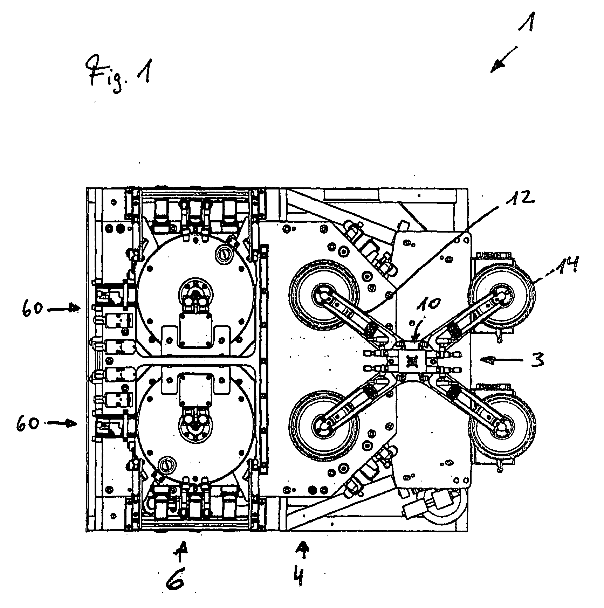

- Fig. 1: eine schematische Draufsicht auf eine Beschichtungsvorrichtung ge- mäß der vorliegenden Erfindung;
- Fig. 2: eine schematische Schnittansicht durch die Beschichtungsvorrichtung, wobei zur Vereinfachung der Darstellung einige Teile weggelassen wurden;
- Fig. 3: eine schematische perspektivische Ansicht von Teilen der erfindungs- gemäßen Beschichtungsvorrichtung.

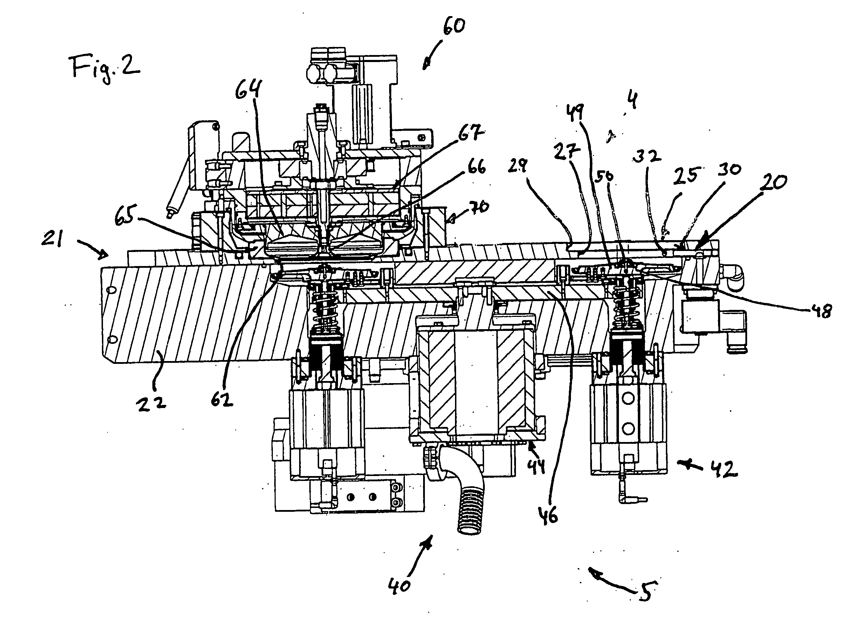

Nachfolgend wird eine Beschichtungsvorrichtung 1 zum Beschichten von scheibenförmigen Substraten für optische Datenträger anhand der Figuren näher erläutert, wobei in den Figuren gleiche Bezugszeichen verwendet werden, um gleiche oder ähnliche Elemente zu bezeichnen. Die Beschichtungsvorrichtung 1 besitzt eine externe Transporteinrichtung 3, einen Be-/Entladeabschnitt 4, eine interne Transporteinrichtung 5 (Fig. 2), sowie einen Beschichtungsabschnitt 6.

Die externe Transporteinrichtung 3 wird durch einen Dreh-Hubhändter 10 gebildet, der vier Tragarme 12 besitzt. Die vier Tragarme 12 sind jeweils an einer nicht näher dargestellten Dreh-Hubwelle befestigt und sind derart angeordnet, dass sie eine X-Form bilden. An ihren freien Enden tragen die Tragarme 12 jeweils einen Aufnahmeteller 14, an deren Unterseite nicht näher dargestellte Substratgreifer, z.B. in Form von Vakuum- und/oder Innenlochgreifern angeordnet sind. Die Aufnahmeteller sind dabei so angeordnet, dass deren Mittelpunkte auf einer Kreislinie liegen, die bezüglich einer Drehachse der nicht dargestellten Dreh-Hubwelle koaxial ist.

Der Be-/Entladeabschnitt 4 der Beschichtungsvorrichtung 1 wird im Wesentlichen durch eine Deckplatte 20 eines Vakuumkammergehäuses 21 gebildet. Wie in Fig. 2 zu erkennen ist, besteht das Vakuumkammergehäuse im Wesentlichen aus einer Grundplatte 22, die eine Vertiefung aufweist, sowie die Deckplatte 20. Die Deckplatte deckt die Vertiefung in der Grundplatte 22 vollständig ab, so dass, wie nachfolgend noch näher erläutert wird, die Vertiefung eine Vakuumtransportkammer bildet.

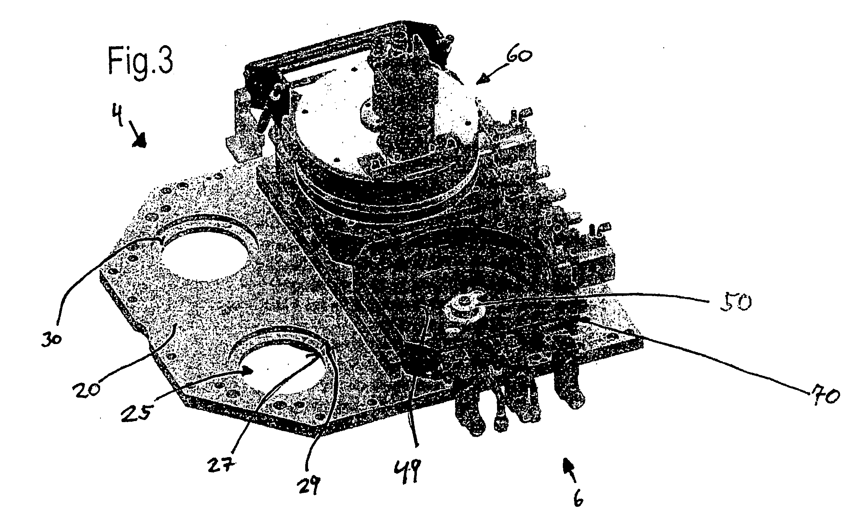

Im Bereich des Be-/Entladeabschnitts 4 weist die Deckplatte 20 zwei Eingabe-/Ausgabeöffnungen 25 auf, die am Besten in den Figuren 2 und 3 zu erkennen sind. Die Eingabeöffnung 25 weist einen unteren Öffnungsabschnitt mit einer runden Innenumfangsfläche 27 sowie einen oberen Abschnitt mit einer runden Innenumfangsfläche 29 auf. Zwischen dem unteren und oberen Abschnitten der Ein-/Ausgabeöffnung 25 wird eine Auflageschulter 30 gebildet.

Die Innenumfangsfläche 27 ist derart bemessen, dass sie das Hindurchführen eines zu beschichtenden scheibenförmigen Substrats ermöglicht. Die Innenumfangsfläche 29 ist derart bemessen, dass sie die teilweise Aufnahme eines Aufnahmetellers 14 der externen Transporteinrichtung 3 ermöglicht, wobei eine Unterseite desselben mit der Auflageschulter 30 in abdichtenden Eingriff kommen kann.

Im Bereich der Innenumfangsfläche 27 ist wenigstens eine Be/Entlüftungsöffnung 32 vorgesehen, deren Funktion nachfolgend noch näher erläutert wird.

Die Mittelpunkte der Ein-/Ausgabeöffnung liegen auf derselben Kreislinie wie auch die Mittelpunkte der Aufnahmeteller 14 und der Abstand zwischen den Ein-/Ausgabeöffnungen entspricht dem Abstand zwischen zwei Aufnahmetellern 14 der externen Transporteinrichtung, um ein gleichzeitiges Be- und Entladen von zwei Substraten an den Ein-/Ausgabeöffnungen zu ermöglichen.

Statt zweier getrennter Ein-/Ausgabeöffnungen ist es auch möglich, eine einzelne Ein-/Ausgabeöffnung vorzusehen, wobei diese das gleichzeitige Be- und Entladen zweiter Substrate ermöglichen sollte.

Die interne Transporteinrichtung 5 besteht im Wesentlichen aus einer Dreheinheit 40 sowie Hubeinheiten 42, von denen zwei in Fig. 2 dargestellt sind. Die Dreheinheit besteht im Wesentlichen aus einem Drehantrieb, wie beispielsweise einem Elektromotor mit einer Abtriebswelle, die mit einem Drehteller 46 verbunden ist. Im Bereich des Außenumfangs des Drehtellers sind Auflageelemente 48 derart aufgenommen, dass sie vom Drehteller 46 abgehoben werden können.

Die Auflageelemente 48 besitzen einen Hauptkörper 49 und einen Aufnahmestift 50, der zum Hauptkörper 49 zentriert aufgenommen ist. Der Hauptkörper 49 besitzt einen Umfang der größer ist als die Innenumfangsfläche 29 der Ein-/Ausgabeöffnung 25. Ferner weist der Hauptkörper 49 ein Dichtungselement, wie beispielsweise einen O-Ring auf, um in einer Übergabeposition gegen eine Unterseite der Deckplatte 20 abzudichten, wie nachfolgend noch näher erläutert wird.

Eine Hubbewegung der Auflageelemente wird durch die Hubeinheiten 42 erreicht, die zu den Ein-/Ausgabeöffnungen ausgerichtet sind, und eine lineare Hubbewegung auf diese zu und von diesen weg bewirken. Die Hubeinheiten 42 erstrecken sich durch entsprechende Öffnungen in der Grundplatte 22 des Vakuumgehäuses 21 in den Vakuumkammerbereich hinein und sind in abgedichteter Weise an der Grundplatte 22 befestigt. In gleicher Weise ist der Elektromotor an der Grundplatte 22 befestigt, wobei sich die Abtriebswelle des Elektromotors 44 in vakuumdichter Weise durch eine entsprechende Öffnung in der Grundplatte 22 hindurch erstreckt.

Der Beschichtungsabschnitt 6 besteht im Wesentlichen aus zwei Zerstäubungskathodenanordnungen 60, die im Bereich zweier Beschichtungsöffnungen 62 in der Deckplatte 20 angeordnet sind.

Die Zerstäubungskathodenanordnung 60 besitzt einen allgemein bekannten Aufbau mit einem zu zerstäubenden Target 64, Außen- und Innenmasken 65, 66 sowie einer rotierenden Magnetanordnung 67.

Die Zerstäubungskathodenanordnung 60 liegt auf einem fest mit der Deckplatte 20 verbundenen Aufnahmeelement 70 auf, wobei die Außenmaske 65 direkt auf der Deckplatte 20 aufliegt. Dabei erstreckt sich die Außenmaske 65 wenigstens teilweise in die Beschichtungsöffnung 62 hinein. Die Zerstäubungskathodenanordnung 60 ist vakuumdicht mit dem Aufnahmeelement 70 bzw. der Deckplatte 20 verbunden.

Nachfolgend wird der Betrieb der Beschichtungsvorrichtung 1 näher erläutert, wobei zunächst der Betrieb für die gleichzeitige Beschichtung von mehreren Substraten für Single- oder Dual-Layer-Formate beschrieben wird.

In den Zerstäubungskathodenanordnungen 60 befinden sich Targets 64 mit dem gleichen oder unterschiedlichen Targetmaterialien, wobei gleiche Materialien in der Regel für Single-Layer-Formate vorgesehen werden und unterschiedliche Materialien in der Regel für Dual-Layer-Formate.

Über die externe Transporteinrichtung 3 werden zunächst zwei Substrate von einer nicht näher dargestellten externen Transportvorrichtung einer Anlage zur Herstellung optischer Datenträger abgenommen und anschließend in den Bereich der Ein-/Ausgabeöffnungen 25 bewegt. Dabei wird jeweils ein Substrat über den Dreh-Hub-Händler 10 über eine Ein-/Ausgabeöffnung bewegt. Anschließend führt der Dreh-Hub-Händler 10 eine Absenkbewegung durch, um die Aufnahmeteller teilweise in die Ein-/Ausgabeöffnungen 25 hineinzubewegen und in abdichtenden Kontakt mit der Auflageschulter 30 zu bringen. Zu diesem Zeitpunkt befinden sich die Auflageteller 48 in einer angehobenen Position und die Substrate werden auf den Aufnahmestiften 50 abgelegt. Über die Entlüftungsöffnung 32 wird eine zwischen dem Aufnahmeteller 14 und den Auflageelementen 48 gebildete Schleusenkammer entlüftet. Anschließend werden die Auflageelemente 48 abgesenkt, so dass sich die Substrate nunmehr in der Vakuum-Transportkammer befinden. Durch eine 180° Drehung des Drehtellers 46 werden die Substrate gleichzeitig in den Bereich jeweiliger Beschichtungsöffnungen 62 gebracht. In dieser Position werden die Auflageelemente 48 durch entsprechende Hubeinheiten 42 angehoben, und zwar derart, dass die zu beschichtenden Substrate mit der Außenmaske 65 am Außenumfang und der Innenmaske 66 im Bereich eines Mittellochs in Eingriff kommen. Anschließend wird die Zerstäubungskathodenanordnung in bekannter Weise angesteuert, um eine Beschichtung der Substrate durch Zerstäubung der Targets 64 vorzunehmen.

Anschließend werden die Auflageelemente 48 wieder abgesenkt und durch 180° Drehung des Drehtellers 46 wiederum in den Bereich der Ein-/Ausgabeöffnungen 25 gebracht. Dort werden die Auflageelemente 48 mit den darauf befindlichen beschichteten Substraten wiederum angehoben. Die zwischen den Auflageelementen 48 und den Aufnahmetellern 14 gebildeten Kammern werden belüftet und die Substrate werden durch entsprechende Greifer an dem Aufnahmeteller 14 aufgenommen, und anschließend durch eine Hubbewegung des Dreh-Hub-Händlers abgehoben. Durch eine anschließende Drehbewegung werden sie aus dem Bereich der Ein-/Ausgabeöffnungen 25 wegtransportiert.

Wie sich aus der obigen Beschreibung ergibt, werden jeweils zwei Substrate gleichzeitig beladen, zu jeweiligen Beschichtungspositionen befördert, dort gleichzeitig beschichtet, anschließend wieder zu Entladepositionen befördert und dort entnommen. Während die Substrate in den Beschichtungspositionen beschichtet werden, können an den Ein-/Ausgabeöffnungen 25 schon beschichtete Substrate entnommen und neue Substrate in die Vorrichtung 1 geladen werden.

Die Anlage erreicht dadurch einen sehr hohen Durchsatz, der ungefähr doppelt so groß ist wie der Durchsatz von Anlagen mit nur einer Zerstäubungskathodenanordnung.

Der obige Beschichtungsvorgang wird als paralleler Beschichtungsvorgang beschrieben, da parallel zwei Substrate jeweils einfach beschichtet werden.

Nachfolgend wird nunmehr ein serieller Beschichtungsvorgang beschrieben, bei dem Substrate mit zwei oder mehr meist unterschiedlichen Schichten beschichtet werden. In den Zerstäubungskathodenanordnungen 60 befinden sich gemäß der nachfolgenden Beschreibung Targets 64 aus unterschiedlichen Materialien. Es ist aber auch denkbar, Targets aus gleichen Materialien vorzusehen, um zwei Schichten aus dem gleichen Material auf ein Substrat aufzubringen.

Wiederum werden zwei Substrate über die Ein-/Ausgabeöffnungen 25 in der oben beschriebenen Art und Weise in die Beschichtungsvorrichtung 1 geladen. Anschließend werden die Substrate durch den Drehteller 46 derart transportiert, dass eines der Substrate unter einer ersten der Beschichtungsöffnungen 62 liegt. Das andere Substrat liegt zu diesem Zeitpunkt nicht im Bereich einer Beschichtungsöffnung. Das im Bereich der ersten Beschichtungsöffnung 62 liegende Substrat wird durch eine entsprechende Hubbewegung der Hubeinheit 62 in eine Beschichtungsposition angehoben und durch die entsprechende Zerstäubungskathodenanordnung beschichtet. Anschließend wird das Substrat wieder abgesenkt und der Drehteller 46 wird weiterbewegt, und zwar derart, dass sich das zuvor beschichtete Substrat nunmehr im Bereich einer zweiten der Beschichtungsöffnungen 62 befindet, während sich das zuvor nicht beschichtete Substrat im Bereich der ersten Beschichtungsöffnung 62 befindet. Nunmehr werden beide Substrate durch die entsprechenden Hubeinheiten angehoben und durch die jeweiligen Zerstäubungskathodenanordnungen 60 beschichtet. Anschließend werden sie wieder abgesenkt und der Drehteller 46 wird wiederum weitergetaktet, und zwar derart, dass sich das nunmehr zweifach beschichtete Substrat im Bereich einer Ein-/Ausgabeöffnung 25 befindet, während das einfach beschichtete Substrat sich im Bereich der zweiten Beschichtungsöffnung 62 befindet. Dieses Substrat wird durch die entsprechende Hubeinheit 42 in die Beschichtungsposition angehoben und durch die Zerstäubungskathodenanordnung 60 beschichtet.

Anschließend wird es wieder abgesenkt und durch eine Bewegung des Drehtellers 46 in den Bereich einer Ein-/Ausgabeöffnung 65 gebracht. Dabei befinden sich nunmehr beide beschichteten Substrate im Bereich von Ein-/Ausgabeöffnungen 25 und sie werden in der oben beschriebenen Art und Weise aus der Beschichtungsvorrichtung 1 entnommen.

Bei diesem seriellen Betrieb können Substrate mit mehreren Schichten innerhalb einer einzelnen Beschichtungsvorrichtung beschichtet werden.

Bei dem zuvor beschriebenen Prozessablauf ist es möglich, während beide Substrate durch die jeweiligen Zerstäubungskathodenanordnungen beschichtet werden, im Bereich der Ein-/Ausgabeöffnungen 25 neue Substrate in die Vorrichtung 1 zu laden, bzw. schon beschichtete Substrate zu entladen, so dass nach jeder Drehbewegung 46 immer ein noch nicht beschichtetes Substrat in den Bereich der ersten Beschichtungsöffnung 62 gelangt, während ein einfach beschichtetes Substrat in den Bereich der zweiten Beschichtungsöffnung 62 gelangt.

Die Erfindung wurde zuvor anhand bevorzugter Ausführungsbeispiele im Detail erläutert, ohne jedoch auf die konkret dargestellten Ausführungsbeispiele beschränkt zu sein. So können beispielsweise unterschiedliche Anzahlen von Ein-/Ausgabeöffnungen sowie unterschiedliche Beschichtungsöffnungen mit entsprechenden Zerstäubungskathodenanordnungen vorgesehen sein. Die Vorrichtung besteht im Allgemeinen aus 1 bis n Ein-/Ausgabeöffnungen, die insgesamt wenigstens 2 bis n Substrate aufnehmen können, und 2 bis n Beschichtungsöffnungen mit entsprechenden Zerstäubungskathodenanordnungen, an denen insgesamt n Substrate gleichzeitig beschichtet werden können. Die Zahl der Ein-/Ausgabeöffnungen und der Beschichtungsöffnungen ist nicht notwendigerweise an die Zahl der Substrate gebunden. Es ist auch denkbar über entsprechend größere Öffnungen zwei oder mehr Substrate einzuschleusen bzw. zu beschichten.

Sowohl im parallelen als auch im seriellen Betrieb ist es möglich, unterschiedliche Materialien für die Targets zu verwenden. Ferner ist es auch denkbar, im seriellen Betrieb gleiche Materialien für die Targets zu verwenden, wenn beispielsweise zwei Lagen desselben Materials ausgebildet werden sollen.

## Patentansprüche

1. Vorrichtung (1) zum Beschichten von scheibenförmigen Substraten für optische Datenträger, die folgendes aufweist:
eine Gehäuse (21) zur Bildung einer Vakuumkammer, wobei das Gehäuse (21) wenigstens zwei Beschichtungsöffnungen (62) und wenigstens eine Ein-/Ausgabeöffnung (25) aufweist, wobei wenigstens zwei Substrate gleichzeitig über die Ein-/Ausgabeöffnung(en) (25) in die Vakuumkammer hinein bzw. aus dieser heraus geladen werden können;
wenigstens zwei Zerstäubungskathodenanordnungen (60), wobei jede Zerstäubungskathodenanordnung (60) eine der Beschichtungsöffnungen (62) des Gehäuses (21) von außen Vakuumdicht verschließt, und wobei
die Zerstäubungskathodenanordnungen (60) jeweils ein zu zerstäubendes Target (64) besitzen; und
eine innerhalb der Vakuumkammer angeordnete Transporteinrichtung (5) zum gleichzeitigen Transport von wenigstens vier Substraten zwischen der wenigstens einen Ein-/Ausgabeöffnung (25) und den Beschichtungsöffnungen (62); **gekennzeichnet durch**
eine Steuereinheit, die in der Lage ist, die Transporteinrichtung (5) in Abhängigkeit von einem erwünschten Beschichtungsergebnis sowohl in einer seriellen Betriebsart als auch einer parallelen Betriebsart anzusteuern, wobei die Substrate bei der seriellen Betriebsart von wenigstens einer Ein-/Ausgabeöffnung (25) sequentiell zu einer ersten Beschichtungsöffnung (62), einer zweiten Beschichtungsöffnung (62) und anschließend zu wenigstens einer Ein-/Ausgabeöffnung (25) transportiert werden und wobei die Substrate bei der parallelen Betriebsart von wenigstens einer Ein-/Ausgabeöffnung (25) zu einer Beschichtungsöffnung (62) und anschließend direkt zu wenigstens einer Ein-/Ausgabeöffnung (25) transportiert werden.

2. Vorrichtung nach Anspruch 1, **dadurch gekennzeichnet, dass** die Ein-/Ausgabeöffnung(en) (25) und die Beschichtungsöffnungen (62) in einer gemeinsamen Wand (20) des Gehäuses (21) ausgebildet sind.

3. Vorrichtung nach einem der vorhergehenden Ansprüche, **dadurch gekennzeichnet, dass** wenigstens zwei Zerstäubungskathodenanordnungen (60) Targets (64) mit unterschiedlichen Materialien aufweisen.

4. Vorrichtung nach einem der vorhergehenden Ansprüche, **dadurch gekennzeichnet, dass** die Transporteinrichtung (5) die Substrate im Wesentlichen in einer horizontalen Ausrichtung trägt.

5. Vorrichtung nach einem der vorhergehenden Ansprüche, **dadurch gekennzeichnet, dass** die unterschiedlichen Öffnungen (25, 62) in einer oberen Wand (20) des Gehäuses (21) ausgebildet sind.

6. Vorrichtung nach einem der vorhergehenden Ansprüche, **dadurch gekennzeichnet, dass** die Transporteinrichtung (5) eine drehbare Transporteinheit (46) mit wenigstens vier Aufnahmen (48) und wenigstens eine separate Hubeinheit (42) aufweist.

7. Vorrichtung nach Anspruch 6, **dadurch gekennzeichnet, dass** wenigstens zwei separate Hubeinheiten (42) vorgesehen sind.

8. Vorrichtung nach Anspruch 6 oder 7, **dadurch gekennzeichnet, dass** Hubelemente der Hubeinheit(en) (42) mit den jeweiligen Öffnungen (25, 62) des Gehäuses ausgerichtet sind.

9. Verfahren zum Beschichten von scheibenförmigen Substraten für optische Datenträger unter Verwendung einer Vorrichtung (1) nach einem der vorhergehenden Ansprüche, mit folgenden Schritten:
gleichzeitiges Laden von wenigstens zwei Substraten über die wenigstens eine Ein-/Ausgabeöffnung (25) in die Vakuumkammer;
gleichzeitiger Transport der Substrate durch die Transporteinrichtung (5) zu einer jeweiligen Beschichtungsöffnung (62);
gleichzeitiges Beschichten der Substrate mit einer ersten Schicht an der jeweiligen Beschichtungsöffnung (62).

10. Verfahren nach Anspruch 9, **dadurch gekennzeichnet, dass** die Substrate nach der Beschichtung mit der ersten Schicht gleichzeitig durch die Transporteinrichtung (5) zur wenigstens einen Ein-/Ausgabeöffnung (25) transportiert werden, wo sie gleichzeitig aus der Vakuumkammer entnommen werden.

11. Verfahren zum Beschichten von scheibenförmigen Substraten für optische Datenträger unter Verwendung einer Vorrichtung (1) nach einem der vorhergehenden Ansprüche, mit folgenden Schritten:
Laden eines Substrats über die wenigstens eine Ein-/Ausgabeöffnung (25) in die Vakuumkammer;
Transport des Substrats durch die Transporteinrichtung (5) zu einer ersten Beschichtungsöffnung (62);
Beschichten des Substrats mit einer ersten Schicht an der ersten Beschichtungsöffnung (62);
Transport des Substrats durch die Transporteinrichtung (5) zu einer zweiten Beschichtungsöffnung (62);
Beschichten des Substrats mit einer zweiten Schicht an der zweiten Beschichtungsöffnung (62), wobei die erste und zweite Schicht aus unterschiedlichen Materialien bestehen.

12. Verfahren nach Anspruch 11, **dadurch gekennzeichnet, dass** an der ersten und zweiten Beschichtungsöffnung (62) gleichzeitig unterschiedliche Substrate beschichtet werden.

13. Verfahren nach einem der Ansprüche 9 bis 12, **dadurch gekennzeichnet, dass** die Substrate während der Beschichtung stationär gehalten werden.

## Claims

1. An apparatus (1) for coating disk shaped substrates for optical data carriers, said apparatus comprising:
a housing (21) for forming a vacuum chamber, wherein said housing (21) has at least two coating openings (62) and at least one
inputs/output opening (25), wherein at least two substrates may be loaded via said input/output opening(s) (25) into the vacuum chamber or may be taken from said vacuum chamber, simultaneously;
at least two sputtering cathode arrangements (60) wherein each sputtering cathode arrangement (60) hermetically closes one of said coating openings (62) of said housing (21) from the outside, and wherein each of said sputtering cathode arrangements (60) has a target (64) to be sputtered; and
a transport device (5) arranged within said vacuum chamber for simultaneously transporting at least four substrates between said at least one input/output opening (25) and the coating opening (62);
**characterized by**
a control unit capable of driving the transport device (5) in accordance with a desired coating result in a serial mode of operation as well as a parallel mode of operation, wherein said substrates in said serial mode of operation are sequentially transported from said at least one input/output opening (25) to a first coating opening (62), to a second coating opening (62) and subsequently to said at least one input/output opening (25), and wherein said substrate are transported in said parallel mode of operation from said at least one inlet/outlet opening (25) to a coating opening (62) and subsequently directly to said input/output opening (25).

2. Apparatus according to claim 1, **characterized in that** said input/output-opening(s) (25) and the coating openings (62) are formed in a common wall (20) of said housing (21).

3. Apparatus according to one of the preceding claims, **characterized in that** at least two sputtering cathode arrangements (60) comprise targets (64) having different materials.

4. Apparatus according to one of the preceding claims, **characterized in that** said transport device (5) carries said substrates in a substantially horizontal orientation.

5. Apparatus according to one of the preceding claims, **characterized in that** said different openings (25, 62) are formed in an upper wall (60) of said housing (21).

6. Apparatus according to one of the preceding claims, **characterized in that** said transport device (5) comprises a rotatable transport unit (46) having at least four receptacles (48) and at least one separate lift unit (42).

7. Apparatus according to claim 6 **characterized in that** at least two separate lift units (42) are provided.

8. Apparatus according to claim 6 or 7 **characterized in that** lift elements of said lift unit(s) (42) are aligned with the respective openings (25, 62) in said housing.

9. A method for coating disk shaped substrates for optical data carriers using an apparatus (1) according to one of the preceding claims, said method comprising:
simultaneously loading at least two substrates via said at least one input/output opening (25) in said vacuum chamber;
simultaneously transporting said substrates by said transport device (5) to a respective coating opening (62);
simultaneously coating said substrates with a first layer at said respective coating opening (62).

10. The method of claim 9, **characterized in that** said substrates after being coated with said first layer are simultaneously transported by said transport device (5) to said at least one input/output opening (25), where they are simultaneously removed from said vacuum chamber.

11. A method for coating disk shaped substrates for optical data carriers using an apparatus (1) according to one of the preceding claims, said method comprising:
loading a substrate via said at least one input/output opening (25) into said vacuum chamber;
transporting said substrate via said transport device (5) to a first coating opening (62);
coating said substrate with a first layer at said first coating opening (62);
transporting the substrate via the transport device (5) to a second coating opening (62);
coating the substrate with a second layer at said second coating opening (62), wherein the first and second layer are made up of different materials.

12. The method of claim 11, **characterized in that** at said first and second coating openings (62) different substrates are simultaneously coated.

13. The method of anyone of claims 9 to 12, **characterized in that** the substrates are held stationary during the coating step.

## Revendications

1. Dispositif (1) destiné au revêtement de substrats en forme de disques destinés à des supports de données optiques, lequel dispositif comporte :
- un carter (21) pour former une chambre sous vide, le carter (21) comportant au moins deux ouvertures de revêtement (62) et au moins une ouverture d'entrée et de sortie (25), au moins deux substrats pouvant être chargés simultanément dans la chambre sous vide ou hors de celle-ci par l'intermédiaire de/des ouverture(s) d'entrée et de sortie (25) ;
- au moins deux systèmes de cathodes de pulvérisation (60), chaque système de cathodes de pulvérisation (60) obturant, de manière étanche de l'extérieur, l'une des ouvertures de revêtement (62) du carter (21), et les systèmes de cathodes de pulvérisation (60) comportant chacun une cible (64) à pulvériser ; et
- un dispositif de transport (5), disposé à l'intérieur de la chambre sous vide et destiné à transporter simultanément au moins quatre substrats entre ladite au moins une ouverture d'entrée et de sortie (25) et les ouvertures de revêtement (62) ;
**caractérisé par** une unité de commande, qui est apte à activer en mode de fonctionnement sériel, de même qu'en mode de fonctionnement parallèle le dispositif de transport (5) en fonction d'un résultat de revêtement souhaité, lesdits substrats dans le mode de fonctionnement sériel étant transportés par séquence depuis au moins une ouverture d'entrée et de sortie (25) vers une première ouverture de revêtement (62), une deuxième ouverture de revêtement (62) et, ensuite, vers au moins une ouverture d'entrée et de sortie (25), et lesdits substrats, dans le mode de fonctionnement parallèle, étant transportés depuis au moins une ouverture d'entrée et de sortie (25) vers une ouverture de revêtement (62) et, ensuite, directement vers une ouverture d'entrée et de sortie (25).

2. Dispositif selon la revendication 1, **caractérisé en ce que** la/les ouverture(s) d'entrée et de sortie (25) et les ouvertures de revêtement (62) sont réalisées dans une paroi (20) commune du carter (21).

3. Dispositif selon l'une quelconque des revendications précédentes, **caractérisé en ce qu'**au moins deux systèmes de cathodes de pulvérisation (60) comportent des cibles (64) avec des matériaux différents.

4. Dispositif selon l'une quelconque des revendications précédentes, **caractérisé en ce que** le dispositif de transport (5) porte les substrats sensiblement dans un alignement horizontal.

5. Dispositif selon l'une quelconque des revendications précédentes, **caractérisé en ce que** les différentes ouvertures (25, 62) sont réalisées dans une paroi supérieure (20) du carter (21).

6. Dispositif selon l'une quelconque des revendications précédentes, **caractérisé en ce que** le dispositif de transport (5) comporte une unité de transport (46) rotative avec au moins quatre logements (48), et au moins une unité de levage (42) séparée.

7. Dispositif selon la revendication 6, **caractérisé en ce qu'**il est prévu au moins deux unités de levage (42) séparées.

8. Dispositif selon la revendication 6 ou 7, **caractérisé en ce que** des éléments de levage de/des unité(s) de levage (42) sont alignés avec les ouvertures (25, 62) respectives du carter.

9. Procédé de revêtement de substrats en forme de disques destinés à des supports de données optiques, moyennant l'utilisation d'un dispositif (1) selon l'une quelconque des revendications précédentes, lequel procédé comporte les étapes suivantes :
- chargement simultané d'au moins deux substrats dans la chambre sous vide par l'intermédiaire de ladite au moins une ouverture d'entrée et de sortie (25) ;
- transport simultané des substrats par le dispositif de transport (5) vers une ouverture de revêtement (62) respective ;
- revêtement simultané des substrats avec une première couche au niveau de l'ouverture de revêtement (62) respective.

10. Procédé selon la revendication 9, **caractérisé en ce que** les substrats, après le dépôt de la première couche, sont transportés simultanément par le dispositif de transport (5) vers au moins une ouverture d'entrée et de sortie (25), où ils sont simultanément évacués hors de la chambre sous vide.

11. Procédé de revêtement de substrats en forme de disques destinés à des supports de données optiques, moyennant l'utilisation d'un dispositif (1) selon l'une quelconque des revendications précédentes, lequel procédé comporte les étapes suivantes :
- chargement d'un substrat dans la chambre sous vide par l'intermédiaire de ladite au moins une ouverture d'entrée et de sortie (25) ;
- transport du substrat par le dispositif de transport (5) vers une première ouverture de revêtement (62) ;
- revêtement du substrat avec une première couche au niveau de la première ouverture de revêtement (62) ;
- transport du substrat par le dispositif de transport (5) vers une deuxième ouverture de revêtement (62) ;
- revêtement du substrat avec une deuxième couche au niveau de la deuxième ouverture de revêtement (62), la première et la deuxième couche étant réalisées dans des matériaux différents.

12. Procédé selon la revendication 11, **caractérisé en ce que** des substrats différents sont revêtus simultanément au niveau de la première et de la deuxième ouverture de revêtement (62).

13. Procédé selon l'une quelconque des revendications 9 à 12, **caractérisé en ce que** les substrats sont maintenus en position stationnaire pendant le revêtement.
